Europäisches Patentamt

European Patent Office

Office européen des brevets

(19)

(11) Veröffentlichungsnummer: **0 276 508 B1**

(12) # EUROPÄISCHE PATENTSCHRIFT

(45) Veröffentlichungstag der Patentschrift: **18.03.92**

(21) Anmeldenummer: **87202519.2**

(22) Anmeldetag: **15.12.87**

(51) Int. Cl.⁵: **G01R 33/36**

(54) **Kernresonanzgerät mit durch PIN-Dioden entkoppelter Detektionsspule.**

(30) Priorität: **22.12.86 NL 8603250**

(43) Veröffentlichungstag der Anmeldung:
**03.08.88 Patentblatt 88/31**

(45) Bekanntmachung des Hinweises auf die
Patenterteilung:
**18.03.92 Patentblatt 92/12**

(84) Benannte Vertragsstaaten:
**BE DE FR GB IT SE**

(56) Entgegenhaltungen:
**EP-A- 0 175 129**
**DE-A- 3 203 961**
**US-A- 4 093 911**
**US-A- 4 408 162**

**REVIEW OF SCIENTIFIC INSTRUMENTS, Band
45, Nr. 9, September 1974, Seiten 1159-1163,
American Institute of Physics, New York, US;
K.E. KISMAN et al.: "Coupling scheme and
probe damper for pulsed nuclear magnetic
resonance single coil probe"**

**JOURNAL OF MAGNETIC RESONANCE, Band
62, Nr. 3, Mai 1985, Seiten 397-405, Academic
Press, Inc., New York, US; P. STYLES et al.:
"A concentric surface-coil probe for the production of homogeneous B1 fields"**

(73) Patentinhaber: **N.V. Philips' Gloeilampenfabrieken
Groenewoudseweg 1
NL-5621 BA Eindhoven(NL)**

(72) Erfinder: **Van Heelsbergen, Teunis Robert
c/o INT. OCTROOIBUREAU B.V. Prof. Holstlaan 6
NL-5656 AA Eindhoven(NL)**

(74) Vertreter: **Faessen, Louis Marie Hubertus et al
INTERNATIONAAL OCTROOIBUREAU B.V. 6
Prof. Holstlaan
NL-5656 AA Eindhoven(NL)**

## Beschreibung

Die Erfindung betrifft ein Kernspinresonanzgerät mit einem Magnetsystem zum Erzeugen eines statischen homogenen Hauptmagnetfeldes und von Gradientenmagnetfeldern, mit einer Sendespule zum Erzeugen eines räumlich homogenen Hf-Magnetwechselfeldes in einem Untersuchungsraum mit einem eine Detektionsspule enthaltenden Resonanzkreis zum Detektieren von in einem zu untersuchenden Objekt erzeugten Kernspinresonanzsignalen, mit einem Signalverstärker zum Verstärken und einer Verarbeitungsanordnung zum Verarbeiten der detektierten Resonanzsignale und mit einem Entkoppelkreis zur Abkopplung der Detektionspule beim Sendebetrieb der Sendespule.

Ein derartiges Kernspinresonanzgerät ist aus dem europäischen Patent EP 0 164 164 B1 bekannt. In diesem Patent wurde weiter beschrieben, dass die Sendespule beim Detektieren der Kernspinresonanzsignale von der Empfangsspule und umgekehrt entkoppelt ist. Obgleich die in der Anmeldung beschriebenen Entkopplungen mittels Halbleiterdioden grundsätzlich richtig sind, sind die gegebenen Entkoppelkreise mangelhaft und verbesserungsfähig.

Der Erfindung liegt die Aufgabe zugrunde, ein Kernspinresonanzgerät zu schaffen, das einen elektronischen Entkoppelkreis für die Detektionsspule enthält, in dem die Entkopplung weiter verbessert ist.

Zur Lösung dieser Aufgabe ist ein Kernspinresonanzgerät erfindungsgemäss dadurch gekennzeichnet, dass der Entkoppelkreis PIN-Dioden enthält, von denen wenigstens eine mit dem Resonanzkreis in Reihe geschaltet ist, und von denen wenigstens eine zweite mit einer Verbindungsleitung in Reihe geschaltet ist, die das von der Detektionsspule detektierte Signal dem Signalverstärker zuführt. Bei einem Kernspinresonanzgerät mit einem derartigen elektronischen Entkoppelkreis wird erreicht, dass sowohl der Resonanzkreis unterbrochen ist, so dass er nicht mehr auf die Arbeitsfrequenz der Sendemagnetspule abgestimmt ist, als auch die Verbindungsleitung unterbrochen ist, die die Detektionsspule mit dem Signalverstärker verbindet, so dass darin ebenfalls kein Hf-Strom fliessen kan.

Aus der europäische Patentanmeldung Nr. 0 175 129 ist ein Kernspinresonanzgerät bekannt mit einer Anzahl Oberflächenspulen die sich in einer Ebene befinden, zum Senden von Hochfrequenzimpulsen und zum Empfangen von NMR-Signalen. Es handelt sich dabei um segmentierte Spulen, wobei Segmente voneinander entkopelt werden können mit einer zwei entgegengeschaltete PIN-Dioden und drei Zusatzspulen enthaltenden Entkopplungsschaltung zur Entkopplung von Segmenten. Mit einer einem Knotenpunkt der PIN-Dioden zuführbaren Spannung kann die Entkopplungsschaltung niederohmig angesteuert werden. Diese Entkopplungsschaltung dient also einem ganz anderen Zweck als bei der vorliegenden Erfindung.

Ausführungsbeispiele der Erfindung werden nachstehend an Hand der Zeichnung näher erläutert. Es zeigen

Fig. 1 ein erfindungsgemässes Kernspinresonanzgerät,

Fig. 2 einen elektronischen Entkoppelkreis mit einer Detektionsspule für die Anordnung nach der Erfindung, und

Fig. 3 ein bevorzugtes Ausführungsbeispiel eines elektronischen Entkoppelkreises.

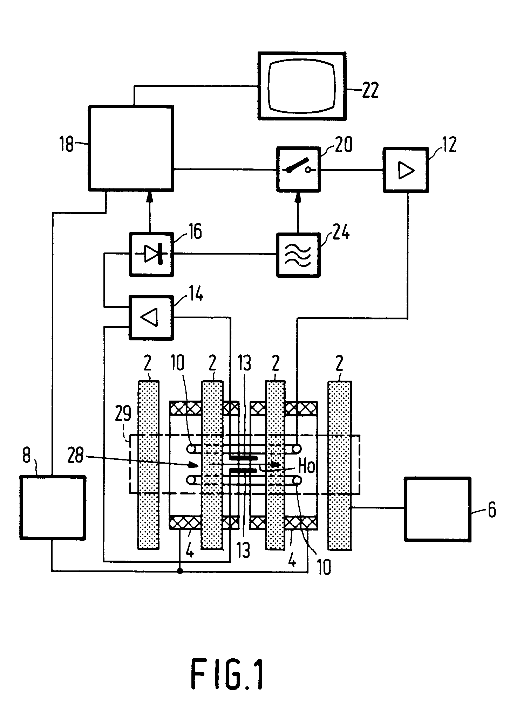

Ein Kernspinresonanzgerät entsprechend Fig. 1 enthält ein Magnetsystem 2 zum Erzeugen eines statischen Magnetfeldes HO, ein Magnetsystem 4 zum Erzeugen magnetischer Gradientenmagnetfelder und Speisequellen 6 und 8 für das Magnetsystem 2 bzw. das Magnetsystem 4. Eine Hf-Magnetspule 10 dient zum Erzeugen eines Hf-Magnetwechselfeldes und ist dazu an die Hf-Quelle 12 angeschlossen. Für die Detektierung des vom Hf-Sendefeldes erzeugten Resonanzsignals in einem zu untersuchenden Objekt wird eine Hf-Spule 13 benutzt, die dazu mit einem Signalverstärker 14 verbunden ist. Der Signalverstärker 14 ist mit einem phasenempfindlichen Gleichrichter 16 verbunden, der an eine zentrale Verarbeitungsanordnung 18 angeschlossen ist. Die zentrale Verarbeitungsanordnung 18 steuert noch einen Modulator 20 für die Hf-Quelle 12, die Speisequelle 8 für die Gradientenmagnetspulen und einen Monitor 22 für die Bildwiedergabe. Ein Hochfrequenzoszillator 24 steuert sowohl den Modulator als auch den Messsignale verarbeitenden phasenempfindlichen Gleichrichter 16. Die in den Magnetsystemen 2 und 4 angeordnete Sendespule 10 schliesst einen Messraum 28 ein, der bei einem Gerät für medizinische diagnostische Messungen gross genug ist zum Aufnehmen eines zu untersuchenden Patienten. Im Untersuchungsraum 28 können also ein statisches Magnetfeld HO, Objektschnitte auswählende Gradientenmagnetfelder und ein räumlich homogenes Hf- Wechselfeld erzeugt werden. Die Hf-Spule 10 muss nach dem Erzeugen eines Hf-Magnetfeldes schnell abgeschaltet werden, weil anschliessend das erzeugte Resonanzsignal beispielsweise mit der Detektionsspule 13 detektiert werden muss. Die Hf-Spule 10 muss abgeschaltet werden, um die Detektierung der Resonanzsignale mit der Oberflächenspule 13 nicht zu stören. Auch ist es unerwünscht, dass beim Einschalten der Hf-Sendespule 10 die Oberflächenspule 13 noch eingeschaltet ist. Dazu werden elektronische Mittel vorgesehen, die die Oberflächenspule 13 unwirksam machen. Wie in dem erwähnten europäischen Patent beschrieben, wird dies durch das Aufnehemen eines Halb-leiterdiodenschalters in den Resonanzkreis verwirk-licht, in dem sich die Detektionsspule 13 befindet. Dieser Schalter unterbricht den Resonanzkreis, wenn die Sendespule 10 aktiv wird. Es hat sich gezeigt, dass das Aufnehmen eines derartigen Halbleiterschalters in den Serienkreis allein ungenügend ist, um eine Störung eines zu erzeugenden Hf-Feldes durch die Sendespule ausreichend zu unterdrücken.

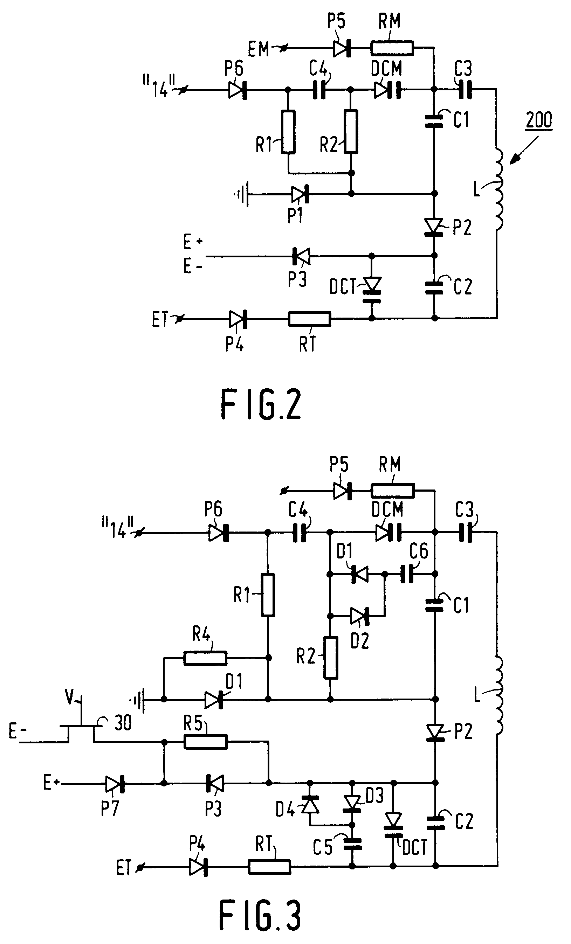

In Fig. 2 ist ein Ausführungsbeispiel einer elektronischen Entkoppelschaltung 200 dargestellt, in der der hier beschriebene Nachteil unterdrückt ist. Der in Fig. 2 dargestellte elektronische Entkoppelkreis 200 enthält eine Detektionsspule L, die in einen Resonanzkreis aufgenommen ist, der weitere drei Kondensatoren C1, C2 und C3 enthält, wobei der Kondensator C2 zum Abstimmen des Resonanzkreises auf die gewünschte Resonanzfrequenz einem Abstimmkondensator DCT parallel geschaltet ist. In den Kreis ist weiter eine PIN-Diode P2 aufgenommen, die zum Unterbrechen des Kreises verwendet wird, wenn die Sendespule 10 (Fig. 1) aktiv sein soll. Die Anode der PIN-Diode P2 ist über eine PIN-Diode P1 mit Mass verbunden, während die Kathode der PIN-Diode P2 über eine dritte PIN-Diode P3 an eine Speisequelle E + oder E-angeschlosen ist. Die Speisequellen E- oder E + liefern eine negative bzw. Eine positieve Spannung. Im ersten Fall leiten die Dioden P1, P2 und P3 und die Detektionsspule L, die Kapazitäten C1, C2 und C3 im Resonanzkreis können aktiv sein. Wenn der PIN-Diode P3 eine positive Spannung (E + ) zugeführt wird, sind die Dioden P1 bis P3 gesperrt und der Resonanzkreis ist unterbrochen. Weiter ist eine PIN-Diode P4 vorgesehen, über die eine Abstimmspannung über einen Widerstand RT der Kathode der Abstimmkapazität DCT zugeführt wird. Die Abstimmkapazität DCT ist eine Kapazitätsdiode. Die PIN-Diode P4 dient daher zum Isolieren der Speisequelle ET, die die Kapazitätsdiode DCT steuert, vom Hf Teil, wenn die Detektionsschaltung durch Anlegen einer positiven Spannung E + an die PIN-Diode P3 abgeschaltet wird. Zum Anpassen des Resonanzkreises (L, C1, C2, C3, DCT) an die Impedanz des Signalverstärkers 14 (Fig. 1), die an den Resonanzkreis angeschlossen wird, ist eine Anpassungskapazität (Kapazitätsdiode) DCM vorgesehen, die mit einer Kapazität C4 in Reihe geschaltet ist. Die verlangte Anpassung wird durch das Abstimmen des Kapazitätswertes über das Anlegen einer Steuerspannung EM über eine PIN-Diode P5 und einen Widerstand RM an die Kathode der Kapazitätsdiode DCM erreicht. Die PIN-Diode P5 dient dazu, gleichfalls die Speisequelle EM zum Anpassen der Impedanz des Resonanzkreises von Hf-Signalen abzuschirmen, sobald die Detektionsspule unwirksam geschaltet wird. Auch ist in die Leitung, die den Resonanzkreis mit dem Signalverstärker 14 (Fig. 1) verbindet, eine PIN-Diode P6 aufgenommen. Der Widerstand R1, der die Kathode der Diode P1 mit der Kathode der PIN-Diode P6 und mit der Kapazität C4 verbindet, sorgt dafür, dass im aktiven Zustand des Resonanzkreises, in dem die PIN-Diode P1 leitet, die PIN-Diode P6 von einem Strom durchflossen wird, so dass diese Diode P6 kein Hindernis für die von der Detektionsspule L empfangenen Signale bildet. Der Widerstand R2 dient zur Lieferung einer Referenzspannung für die Anode der Kapazitätsdiode DCM. Es ist klar, dass in der in Fig. 2 dargestellten Detektionsschaltung die PIN-Diode P6 in der Zuleitung des Resonanzkreises dafür sorgt, dass nach dem Abschalten des Resonanzkreises in der Zuleitung zum Signalverstärker 14 kein Strom mehr fliessen kann. Weiter sorgen die Dioden P4 und P5 dafür, dass auch kein Hf-Strom in den Zuleitungen für die Abstimmkapazität DCT und die Anpassungskapazität DCM fliessen kann.

Ein bevorzugtes Ausführungsbeispiel einer Detektionsschaltung nach der Erfindung ist in Fig. 3 dargestellt. Die Bauteile in Fig. 3, die den Bauteilen in Fig. 2 entsprechen, führen die gleichen Bezugsziffern. Die Kapazitätsdioden DCT und DCM sind parallel geschaltet mit einer Reihenschaltung von zwei parallel geschalteten Dioden D3, D4 bzw. D1, D2 und einer Kapazität C5 bzw. C6. Die Dioden D1 und D2 bzw. D3 und D4 in Reihe mit den Kapazitäten C5 bzw. C6 bilden für die verhältnismässig hohen, im aktiven Zustand der Sendespule erzeugten Hf-Ströme einen Kurzschluss, so dass die Kapazitätsdioden DCT und DCM faktisch kurzgeschlossen sind. Im aktiven Zustand der Detektionsspule bilden diese Dioden D1 und D2, D3 und D4 und die Kapazitäten C5, C6 keinen Kurzschluss infolge der von der Detektionsspule L detektierten kleinen Signale. Die Dioden sind einer Kapazität C5, C6 zum Abblocken der an die Anpassungsdiode DCM und die Abstimmdiode DCT zuzuführenden Ströme in Reihe geschaltet. Mit der in Fig. 3 dargestellten Schaltung wird weiter erreicht, dass im aktiven Zustand der Sendespule erzeugte Hf-Impulse selbst eine Sperrspannung für die PIN-Dioden P1... P6 erzeugen. Zunächst macht die an die PIN-Diode P7 gelegte Steuerspannung von + 300 V den Resonanzkreis unwirksam. Jetzt sind die PIN-Dioden P1 bzw. P3 mit einem Widerstand R4 bzw. R5 überbrückt. Die Widerstände R4 und R5 sorgen dafür, dass die PIN-Diode P2 immer eine Sperrspannung erhält, wodurch die PIN-Diode nach wie vor sperrt. Wenn durch den aktiven Zustand der Sendespule 10 die in der Detktionsspule L erzeugten Spannungen höher als die angelegte Steuerspannung und der Anode der PIN-Diode P7 sind, werden in der Detektionsspule L erzeugte Hf-Spannungen die Kapazität C3 aufladen, wodurch die PIN-Diode P2 ununterbrochen gesperrt bleibt. Die PIN-Diode P7 soll dafür sorgen, dass die möglicherweise mit den Hf-Impulsen erzeugte Spannung aufrechterhalten bleibt, die bis zur Kathode der PIN-Diode P3 aufgeprägt bleibt. Wenn der Detektionskreis in Fig. 3 wiederum in den aktiven Zustand gebracht werden soll, wird der Verbindungspunkt zwischen den Kathoden der PIN-Dioden P7 und P3 über einen Transistor 30, der an seiner Steuerelektrode eine Steuerspannung V empfängt, an eine negative Spannung E- gelegt, so dass die PIN-Dioden P1 und P3 leitend werden und der Kreis mit der Spule L und den Kapazitäten C1 bis C3 einen Resonanzkreis bilden kann. Über den Widerstand R1 leitet dann auch die PIN-Diode P6, so dass die kleinen Spannungen, die beim Empfang von Hf-Signalen in der Detektionsspule L erzeugt werden, dem Signalverstärker 14 zugeführt werden können, der über eine Leitung an die Anode der PIN-Diode P4 angeschlossen ist.

**Patentansprüche**

1. Kernspinresonanzgerät mit einem Magnetsystem (2) zum Erzeugen eines statischen homogenen Hauptmagnetfeldes (HO) und von Gradientenmagnetfeldern, mit einer Sendespule (10) zum Erzeugen eines räumlich homogenen Hf-Magnetwechselfeldes in einem Untersuchungsraum (28), mit einem eine Detektionsspule (13) enthaltenden Resonanzkreis zum Detektieren von in einem zu untersuchenden Objekt erzeugten Kernspinresonanzsignalen, mit einem Signalverstärker (14) zum Verstärken und einer Verarbeitungsanordnung (18) zum Verarbeiten der detektierten Resonanzsignale, und mit einem Entkoppelkreis zur Abkopplung der Detektionsspule (13) beim Sendebetrieb der Sendespule (10), dadurch gekennzeichnet, daß der Entkoppelkreis PIN-Dioden enthält, von denen wenigstens eine dem Resonanzkreis in Reihe geschaltet ist, und von denen wenigstens eine zweite mit einer Verbindungsleitung in Reihe geschaltet ist, die das von der Detektionsspule (13) detektierte Kernspinresonanzsignal dem Signalverstärker (14) zuführt.

2. Kernspinresonanzgerät nach Anspruch 1, dadurch gekennzeichnet, daß mit jeder Speiseleitung, über die den Kapazitätsdioden für die Frequenzabstimmung und/oder die Impedanzanpassung eine Steuerspannung zugeführt wird, PIN-Dioden in Reihe geschaltet sind.

3. Kernspinresonanzgerät nach Anspruch 1 oder 2, dadurch gekennzeichnet, daß die PIN-Dioden alle im gleichen Gleichrichtungssinn geschaltet sind in bezug auf eine Steuerspannungsquelle zum Steuern dieser PIN-Dioden.

**Claims**

1. A nuclear magnetic resonance apparatus, comprising a magnet system (2) for generating a steady, uniform main magnetic field (HO) and gradient magnetic fields, a transmitter coil (10) for generating a spatially uniform RF magnetic alternating field in an examination space (28), a resonant circuit comprising a detection coil (13) for detecting spin resonance signals generated in an object to be examined, a signal amplifier (14) for amplifying and a processing device (18) for processing the detected resonance signals, and an uncoupling circuit for uncoupling the detection coil (13) in the transmission mode of the transmitter coil (10), characterized in that the uncoupling circuit comprises PIN diodes, at least one of which is connected in series with the resonant circuit and at least a second of which is connected in series with a connection lead which transports the spin resonance signal detected by the detection coil (13) to the signal amplifier (14).

2. A nuclear magnetic resonance apparatus as claimed in Claim 1, characterized in that PIN diodes are connected in series with each supply lead via which a control voltage is applied to the varactor diodes for frequency tuning and/or impedance matching.

3. A nuclear magnetic resonance apparatus as claimed in Claim 1 or 2, characterized in that all PIN diodes are connected in the same rectifying sense in relation to a control voltage source for controlling the PIN diodes.

**Revendications**

1. Appareil de résonance magnétique nucléaire comportant un système d'aimants pour produire un champ magnétique principal homogène statique et des champs magnétiques de gradients, une bobine d'émission pour produire un champ magnétique Hf alternant spatialement homogène dans un espace d'examen (28), un circuit de résonance comprenant une bobine de détection (13) pour détecter des signaux de résonance magnétique nucléaire produits dans un objet à examiner, un amplificateur de signaux (14) pour amplifier et un dispositif de traitement (18) pour traiter les signaux de résonance détectés, ainsi qu'un circuit de découplage pour découpler la bobine de détection (13) pendant le mode d'émission de la bobine d'émission (10), caractérisé en ce que le circuit de découplage contient des diodes PIN, dont au moins une est connectée en série avec le circuit de résonance et dont au moins une deuxième est connectée en série avec une ligne de liaison qui applique le signal de résonance magnétique nucléaire détecté par la bobine de détection (13) à l'ampliflcateur de signaux (14).

2.  Appareil de résonance magnétique nucléaire suivant la revendication 1, caractérisé en ce que des diodes PIN sont connectées en série avec chaque conducteur d'alimentation par l'intermédiaire duquel une tension de commande est appliquée aux diodes à capacité variable pour l'accord de fréquence et/ou pour l'adaptation d'impédance.

3.  Appareil de résonance magnétique nucléaire suivant la revendication 1 ou 2, caractérisé en ce que les diodes PIN sont toutes connectées dans le même sens de redressement par rapport à une source de tension de commande servant à commander ces diodes PIN.

FIG.1

FIG.2

FIG.3